# EUROPEAN PATENT APPLICATION

(11) **EP 3 890 038 A1**
(43) Date of publication of application: **06.10.2021**
(21) Application number: 19890449.2
(22) Date of filing: 27.11.2019
(51) Int. Cl.: H01L 41/193, C08F 20/22, C08F 214/22, C08F 214/24, C08J 5/18, C08L 27/16, C08L 33/16

(54) **PIEZOELECTRIC MATERIAL AND COMPOSITION FOR PIEZOELECTRIC MATERIAL**

(30) Priority: 28.11.2018 JP 2018222694
(71) Applicant: Osaka Organic Chemical Industry Ltd., Osaka-shi, Osaka 541-0052 (JP)
(72) Inventor: MANAI, Daisuke, Kashiwara-shi, Osaka 582-0020 (JP); MIZUMORI, Tomoya, Kashiwara-shi, Osaka 582-0020 (JP); KABATA, Masayuki, Kashiwara-shi, Osaka 582-0020 (JP)
(74) Representative: Regimbeau
(86) International application number: PCT/JP2019/046329
(87) International publication number: WO 2020/111106

(57) **Abstract**

The present invention relates to a piezoelectric material, comprising:
a vinylidene fluoride/trifluoroethylene copolymer; and
a (meth)acrylic polymer which contains a structural unit derived from a (meth)acrylic monomer represented by Formula (I): 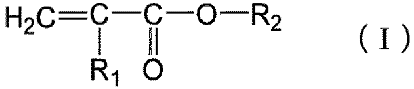 [wherein,
R₁ represents a hydrogen atom or an alkyl group having 1 to 3 carbon atoms, wherein at least one hydrogen atom of R₁ is optionally substituted with a halogen atom; and
R₂ represents a linear or branched alkyl group having 1 to 10 carbon atoms, an alicyclic hydrocarbon group having 3 to 12 carbon atoms which contains an alicyclic structure having 3 to 6 carbon atoms, a phenyl group, or a phenylalkylene group which contains an alkylene group having 1 to 4 carbon atoms,
wherein,
at least one carbon atom of the alkyl group, the alicyclic hydrocarbon group, the phenyl group, and the phenylalkylene group is optionally substituted with -O-, - N-, or -S-,

## Description

### TECHNICAL FIELD

The present invention relates to a piezoelectric material and a composition for a piezoelectric material.

### BACKGROUND ART

A vinylidene fluoride/trifluoroethylene copolymer (P(VDF/TrFE)), which is a ferroelectric polymer that is a copolymer of vinylidene fluoride (VDF) and trifluoroethylene (TrFE), is known as a piezoelectric material having excellent piezoelectric properties and large spontaneous polarization (remnant polarization). This piezoelectric material is used in various piezoelectric elements, such as piezoelectric sensors/transducers and infrared pyroelectric sensors.

Patent Document 1 discloses a piezoelectric film that is produced from a copolymer obtained by copolymerizing vinylidene fluoride and trifluoroethylene at a specific molar ratio. Patent Document 2 discloses a piezoelectric film composed of a mixture of at least two copolymers which are each obtained by copolymerizing vinylidene fluoride and trifluoroethylene and have different polymerization ratios of vinylidene fluoride and trifluoroethylene.

### PRIOR ART DOCUMENTS

### PATENT DOCUMENTS

[Patent Document 1] WO 2016/159354
[Patent Document 2] Japanese Laid-Open Patent Publication No. 2018-119087

### SUMMARY OF THE INVENTION

### PROBLEMS TO BE SOLVED BY THE INVENTION

Although various organic piezoelectric materials such as the above-described ones have been examined, there is still a demand for a further improvement in the piezoelectric properties of an organic piezoelectric material, particularly enhancement of the remnant polarization of a piezoelectric material. A remnant polarization of an organic piezoelectric material is an electrical polarity that remains after the removal of a voltage applied to a polymer material, and a polymer material in a state where a remnant polarization is generated after applying a voltage thereto is an organic piezoelectric material. A piezoelectric material with a large remnant polarization also has a large storable electrical energy per unit volume and, therefore, can be utilized in a wide variety of applications.

In view of the above, an object of the present invention is to provide: a piezoelectric material with a large remnant polarization; and a composition for a piezoelectric material, which is used for obtaining the piezoelectric material.

### MEANS FOR SOLVING PROBLEMS

The present invention encompasses the following preferred modes.
[1] A piezoelectric material, comprising:
   a vinylidene fluoride/trifluoroethylene copolymer; and
   a (meth)acrylic polymer which contains a structural unit derived from a (meth)acrylic monomer represented by Formula (I): 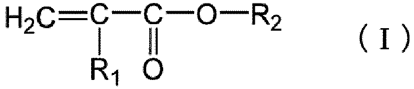 [wherein,
      R₁ represents a hydrogen atom or an alkyl group having 1 to 3 carbon atoms, wherein at least one hydrogen atom of R₁ is optionally substituted with a halogen atom; and
      R₂ represents a linear or branched alkyl group having 1 to 10 carbon atoms, an alicyclic hydrocarbon group having 3 to 12 carbon atoms which contains an alicyclic structure having 3 to 6 carbon atoms, a phenyl group, or a phenylalkylene group which contains an alkylene group having 1 to 4 carbon atoms,
         wherein,
      at least one carbon atom of the alkyl group, the alicyclic hydrocarbon group, the phenyl group, and the phenylalkylene group is optionally substituted with -O-, - N-, or -S-,
      at least one hydrogen atom of the alkyl group, the alicyclic hydrocarbon group, and the alkylene group is optionally substituted with a hydroxy group, an alkyl group having 1 to 6 carbon atoms, and/or an alkoxy group having 1 to 6 carbon atoms,
      at least one hydrogen atom on the phenyl rings of the phenyl group and the phenylalkylene group is optionally substituted with a hydroxy group, an alkyl group having 1 to 4 carbon atoms, an alkoxy group having 1 to 6 carbon atoms, and/or a cyano group, and
      at least one hydrogen atom of R₂ is optionally substituted with a halogen atom,
      with a proviso that at least one hydrogen atom of R₁ and/or R₂ is substituted with a halogen atom].
[2] The piezoelectric material according to [1], wherein the amount of the vinylidene fluoride/trifluoroethylene copolymer is 99 to 40% by mass based on the whole piezoelectric material, and the amount of the (meth)acrylic polymer is 1 to 60% by mass based on the whole piezoelectric material.
[3] The piezoelectric material according to [1] or [2], wherein the vinylidene fluoride/trifluoroethylene copolymer has a weight-average molecular weight of 100,000 or higher.
[4] The piezoelectric material according to any one of [1] to [3], wherein, in the vinylidene fluoride/trifluoroethylene copolymer, the amount of a structural unit derived from vinylidene fluoride is 55 to 90% by mole based on the amount of all structural units.
[5] The piezoelectric material according to any one of [1] to [4], wherein the (meth)acrylic polymer has a weight-average molecular weight of 10,000 to 2,000,000.
[6] A composition for a piezoelectric material, the composition comprising:
   a vinylidene fluoride/trifluoroethylene copolymer; and
   a (meth)acrylic polymer which contains a structural unit derived from a (meth)acrylic monomer represented by Formula (I): 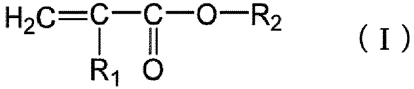 [wherein,
      R₁ represents a hydrogen atom or an alkyl group having 1 to 3 carbon atoms, wherein at least one hydrogen atom of R₁ is optionally substituted with a halogen atom; and
      R₂ represents a linear or branched alkyl group having 1 to 10 carbon atoms, an alicyclic hydrocarbon group having 3 to 12 carbon atoms which contains an alicyclic structure having 3 to 6 carbon atoms, a phenyl group, or a phenylalkylene group which contains an alkylene group having 1 to 4 carbon atoms,
         wherein,
      at least one carbon atom of the alkyl group, the alicyclic hydrocarbon group, the phenyl group, and the phenylalkylene group is optionally substituted with -O-,-N-, or -S-,
      at least one hydrogen atom of the alkyl group, the alicyclic hydrocarbon group, and the alkylene group is optionally substituted with a hydroxy group, an alkyl group having 1 to 6 carbon atoms, and/or an alkoxy group having 1 to 6 carbon atoms,
      at least one hydrogen atom on the phenyl rings of the phenyl group and the phenylalkylene group is optionally substituted with a hydroxy group, an alkyl group having 1 to 4 carbon atoms, an alkoxy group having 1 to 6 carbon atoms, and/or a cyano group, and
      at least one hydrogen atom of R₂ is optionally substituted with a halogen atom,
      with a proviso that at least one hydrogen atom of R₁ and/or R₂ is substituted with a halogen atom].

### EFFECTS OF THE INVENTION

According to the present invention, a piezoelectric material which has a large remnant polarization and excellent piezoelectric properties can be provided.

### MODE FOR CARRYING OUT THE INVENTION

Embodiments of the present invention will now be described in detail. It is noted here, however, that the scope of the present invention is not limited to the embodiments described below, and various modifications can be made without departing from the spirit of the present invention. In the present specification, a numerical range indicated with "to" includes an upper limit and a lower limit of the range.

The piezoelectric material of the present invention comprises: a vinylidene fluoride/trifluoroethylene copolymer; and a specific (meth)acrylic polymer containing halogen atom(s).

### <(Meth)acrylic Polymer>

The (meth)acrylic polymer contained in the piezoelectric material of the present invention contains a structural unit derived from a (meth)acrylic monomer represented by Formula (I): 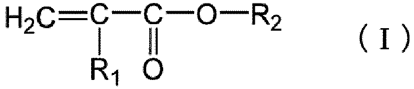 [wherein,
R₁ represents a hydrogen atom or an alkyl group having 1 to 3 carbon atoms, wherein at least one hydrogen atom of R₁ is optionally substituted with a halogen atom; and
R₂ represents a linear or branched alkyl group having 1 to 10 carbon atoms, an alicyclic hydrocarbon group having 3 to 12 carbon atoms which contains an alicyclic structure having 3 to 6 carbon atoms, a phenyl group, or a phenylalkylene group which contains an alkylene group having 1 to 4 carbon atoms,
   wherein,
at least one carbon atom of the alkyl group, the alicyclic hydrocarbon group, the phenyl group, and the phenylalkylene group is optionally substituted with -O-,-N-, or -S-,
at least one hydrogen atom of the alkyl group, the alicyclic hydrocarbon group, and the alkylene group is optionally substituted with a hydroxy group, an alkyl group having 1 to 6 carbon atoms, and/or an alkoxy group having 1 to 6 carbon atoms,
at least one hydrogen atom on the phenyl rings of the phenyl group and the phenylalkylene group is optionally substituted with a hydroxy group, an alkyl group having 1 to 4 carbon atoms, an alkoxy group having 1 to 6 carbon atoms, and/or a cyano group, and
at least one hydrogen atom of R₂ is optionally substituted with a halogen atom,
with a proviso that at least one hydrogen atom of R₁ and/or R₂ is substituted with a halogen atom].

In other words, the (meth)acrylic polymer contained in the piezoelectric material of the present invention is a polymer of monomers including at least a (meth)acrylic monomer represented by the above-described Formula (I). It is noted here that the term "(meth)acryl" used herein means acryl and/or methacryl.

The structural unit derived from a (meth)acrylic monomer represented by Formula (I) is a structural unit represented by the following Formula (II): 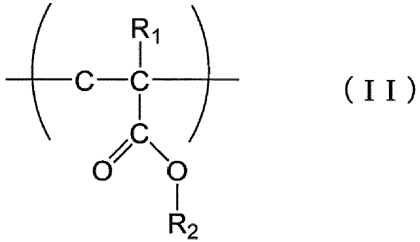 [wherein, R₁ and R₂ have the same meanings as defined for R₁ and R₂ of Formula (I)].

The (meth)acrylic polymer contained in the piezoelectric material of the present invention contains the above-described structural unit represented by Formula (II). In the present specification, the descriptions relating to R₁ and R₂ of Formula (I) also apply to R₁ and R₂ of Formula (II).

In Formula (I), at least one hydrogen atom of R₁ and/or R₂ is substituted with a halogen atom. Accordingly, the (meth)acrylic polymer contained in the piezoelectric material of the present invention contains halogen atom(s). The present inventors discovered that a piezoelectric material, which comprises a vinylidene fluoride/trifluoroethylene copolymer and a (meth)acrylic polymer containing a structural unit derived from a (meth)acrylic monomer represented by Formula (I) in which at least one hydrogen atom of R₁ and/or R₂ is substituted with a halogen atom, has a large remnant polarization. From the standpoint of enhancing the remnant polarization, the halogen atom is preferably at least one atom selected from the group consisting of a fluorine atom, a chlorine atom, a bromine atom and an iodine atom, more preferably a fluorine atom and/or a chlorine atom, still more preferably a fluorine atom. Although the detailed reason why the remnant polarization of the piezoelectric material of the present invention is enhanced is not necessarily clear, it is speculated that, with the specific (meth)acrylic polymer containing a halogen atom, a dipole in its structural unit is increased to a certain extent, and this dipole interacts with a dipole in a structural unit of the vinylidene fluoride/trifluoroethylene copolymer, as a result of which the remnant polarization of the piezoelectric material as a whole is enhanced.

As for the amount of the halogen atom contained in the structural unit derived from a (meth)acrylic monomer represented by Formula (I), from the standpoint of enhancing the remnant polarization of the piezoelectric material, the number of halogen atoms contained in a single structural unit is preferably not less than 1, more preferably not less than 2, still more preferably not less than 3. Examples of a method of determining the amount of the halogen atom include a method of analyzing the (meth)acrylic polymer containing the structural unit derived from a (meth)acrylic monomer, and a method of analyzing the (meth)acrylic monomer that is a raw material monomer. For the analysis of the (meth)acrylic polymer, for example, pyrolysis gas chromatography may be employed. For the analysis of the (meth)acrylic monomer, for example, a nuclear magnetic resonance (NMR) apparatus may be employed; however, the analysis method is not restricted to the above.

From the standpoint of enhancing the remnant polarization of the piezoelectric material, the ratio (molar ratio) of the halogen atom with respect to all atoms constituting the (meth)acrylic polymer is preferably 5% by mole to 70% by mole, more preferably 10% by mole to 60% by mole. The amount of the halogen atom can be determined by, for example, but not limited to: NMR or high-resolution mass spectrometry (HRMS) of the (meth)acrylic polymer. For example, when the (meth)acrylic polymer is analyzed by NMR, the amount of the halogen atom can be determined based on the following equation: (Total area of halogen atom/Area of internal standard substance) × 100.

From the standpoint of increasing the dipole and enhancing the remnant polarization, the halogen atom contained in the (meth)acrylic monomer represented by Formula (I) is preferably in the form of a group selected from the group consisting of a trifluoromethyl group, a difluoroethyl group, a monofluoromethyl group, a trichloromethyl group, a dichloromethyl group, and a monochloromethyl group. In other words, the (meth)acrylic polymer of the present invention preferably contains a structural unit derived from the (meth)acrylic monomer represented by Formula (I), which structural unit contains a group selected from the group consisting of a trifluoromethyl group, a difluoroethyl group, a monofluoromethyl group, a trichloromethyl group, a dichloromethyl group, and a monochloromethyl group.

In Formula (I), R₁ represents a hydrogen atom or an alkyl group having 1 to 3 carbon atoms, and at least one hydrogen atom of R₁ is optionally substituted with a halogen atom. Examples of the alkyl group having 1 to 3 carbon atoms include a methyl group, an ethyl group and a propyl group, and R₁ may be any of these groups in which at least one hydrogen atom is substituted with a halogen atom. The halogen atom is preferably at least one atom selected from the group consisting of a fluorine atom, a chlorine atom, a bromine atom and an iodine atom, more preferably a fluorine atom and/or a chlorine atom, still more preferably a fluorine atom.

Specific examples of R₁ include, but not limited to: a trifluoromethyl group, a difluoromethyl group, a monofluoromethyl group, a trifluoroethyl group, a difluoroethyl group, and a monochloromethyl group.

In Formula (I), R₂ represents (1) a linear or branched alkyl group having 1 to 10 carbon atoms, (2) an alicyclic hydrocarbon group having 3 to 12 carbon atoms which contains an alicyclic structure having 3 to 6 carbon atoms, (3) a phenyl group, or (4) a phenylalkylene group which contains an alkylene group having 1 to 4 carbon atoms. In R₂, at least one carbon atom of the alkyl group, the alicyclic hydrocarbon group, the phenyl group, and the phenylalkylene group is optionally substituted with -O-,-N-, or -S-; at least one hydrogen atom of the alkyl group, the alicyclic hydrocarbon group, and the alkylene group is optionally substituted with a hydroxy group, an alkyl group having 1 to 6 carbon atoms, and/or an alkoxy group having 1 to 6 carbon atoms; and at least one hydrogen atom on the phenyl rings of the phenyl group and the phenylalkylene group is optionally substituted with a hydroxy group, an alkyl group having 1 to 4 carbon atoms, an alkoxy group having 1 to 6 carbon atoms, and/or a cyano group. Further, at least one hydrogen atom of R₂ is optionally substituted with a halogen atom.

The phrase "at least one hydrogen atom of R₂ is optionally substituted with a halogen atom" used herein means that, for example, when R₂ represents the above-described (1) linear or branched alkyl group having 1 to 10 carbon atoms, at least one hydrogen atom contained in the linear or branched alkyl group may be substituted with a halogen atom, or means that, when at least one hydrogen atom of the alkyl group is substituted with a hydroxy group, an alkyl group having 1 to 6 carbon atoms and/or an alkoxy group having 1 to 6 carbon atoms, at least one hydrogen atom in the substituting alkyl group having 1 to 6 carbon atoms and/or alkoxy group having 1 to 6 carbon atoms may be substituted with a halogen atom. The same also applies to those cases where R₂ is any of the above-described (2) to (4). Examples of the halogen atom include those atoms exemplified above for R₁, and the preferred descriptions relating to the halogen atom of R₁ also applied to R₂.

The number of carbon atoms of the alkyl groups in the alkyl group having 1 to 6 carbon atoms and the alkoxy group having 1 to 6 carbon atoms may be 1 to 4, preferably 1 to 2. The alkyl groups in the alkyl group having 1 to 6 carbon atoms and the alkoxy group having 1 to 6 carbon atoms may each be linear or branched.

When R₂ in Formula (I) represents (1) a linear or branched alkyl group having 1 to 10 carbon atoms, from the standpoint of the productivity of the (meth)acrylic monomer represented by Formula (I), the number of carbon atoms of the alkyl group is preferably 1 to 6, more preferably 1 to 4. In the present specification, the alkyl group may be linear or branched. Examples of the alkyl group include a methyl group, an ethyl group, an *n*-propyl group, an isopropyl group, an *n*-butyl group, an isobutyl group, a *sec*-butyl group, a *tert*-butyl group, an *n*-pentyl group, an isopentyl group, a neopentyl group, a 1,1-dimethylpropyl group, an isoamyl group, an *n*-hexyl group, an isohexyl group, and an *n*-octyl group. At least one carbon atom of the alkyl group having 1 to 10 carbon atoms is optionally substituted with -O-, -N- or -S-, and at least one hydrogen atom of the alkyl group having 1 to 10 carbon atoms is optionally substituted with a hydroxy group, an alkyl group having 1 to 6 carbon atoms, and/or an alkoxy group having 1 to 6 carbon atoms.

Examples of the alkyl group having 1 to 10 carbon atoms that is substituted with a hydroxy group include a hydroxymethyl group, a hydroxyethyl group, a hydroxy-*n-*propyl group, a hydroxyisopropyl group, a hydroxy-*n*-butyl group, a hydroxyisobutyl group, and a hydroxy-*tert*-butyl group.

The alkyl group having 1 to 10 carbon atoms that is substituted with an alkyl group having 1 to 6 carbon atoms is a group in which an alkyl group having 1 to 10 carbon atoms constitutes a main chain, and at least one hydrogen atom of this alkyl group is substituted with an alkyl group having 1 to 6 carbon atoms. The number of carbon atoms of the alkyl group as a whole may be greater than 10, as long as the number of carbon atoms of the alkyl moiety constituting the main chain is 1 to 10. Examples of such an alkyl group include a 2-ethylhexyl group. It is noted here that, when the number of carbon atoms of the alkyl group as a whole is 10 or less, this group is also included in the definition of a branched alkyl group having 1 to 10 carbon atoms.

The alkyl group having 1 to 10 carbon atoms that is substituted with an alkoxy group having 1 to 6 carbon atoms is preferably an alkyl group having 1 to 6 carbon atoms that is substituted with an alkoxy group having 1 to 6 carbon atoms. Examples of such a group include a methoxyethyl group, an ethoxyethyl group, and a methoxybutyl group.

Examples of the alkyl group having 1 to 10 carbon atoms that is substituted with a hydroxy group and an alkoxy group having 1 to 6 carbon atoms include groups that contain a hydroxyalkoxy group having 1 to 6 carbon atoms and an alkyl group having 1 to 6 carbon atoms, specifically a hydroxymethoxyethyl group, a hydroxyethoxyethyl group, and a hydroxypropyloxypropyl group.

Among the above-described alkyl groups, from the standpoint of availability, an alkyl group having 1 to 6 carbon atoms that is optionally substituted with a hydroxy group and/or an alkoxy group having 1 to 2 carbon atoms is preferred, an alkyl group having 1 to 4 carbon atoms that is optionally substituted with a hydroxy group and/or an alkoxy group having 1 to 2 carbon atoms is more preferred, and an alkyl group having 1 to 2 carbon atoms that is optionally substituted with a hydroxy group and/or an alkoxy group having 1 to 2 carbon atoms is still more preferred.

Among the above-described alkyl groups, from the standpoint of the productivity of the (meth)acrylic monomer represented by Formula (I), R₂ in Formula (I) preferably represents (1) a linear or branched alkyl group having 1 to 10 carbon atoms, in which at least one carbon atom is substituted with -O-. This R₂ is, for example, a group represented by Formula (III):

-((CH₂)ₘ-O-)ₙ-X (III)

[wherein,
m and n each independently represent 2 or 3,
X represents a hydrogen atom or a methyl group, and
at least one hydrogen atom in Formula (III) is optionally substituted with a hydroxy group, an alkyl group having 1 or 2 carbon atoms, and/or an alkoxy group having 1 to 6 carbon atoms].

At least one hydrogen atom of this group is optionally substituted with a halogen atom. Preferred examples of such a group include a trifluoromethoxyethyl group and a trifluoromethoxypropyl group.

In the above-described linear or branched alkyl group having 1 to 10 carbon atoms which is, depending on the case, optionally substituted with, for example, a hydroxy group, an alkyl group having 1 to 6 carbon atoms and/or an alkoxy group having 1 to 6 carbon atoms, at least one hydrogen atom is optionally substituted with a halogen atom.

When R₂ in Formula (I) represents (2) an alicyclic hydrocarbon group having 3 to 12 carbon atoms which contains an alicyclic structure having 3 to 6 carbon atoms, the alicyclic structure having 3 to 6 carbon atoms is, for example, cyclohexane. At least one carbon atom of the alicyclic hydrocarbon group having 3 to 12 carbon atoms is optionally substituted with -O-, -N- or -S-, and at least one hydrogen atom of the alicyclic hydrocarbon group having 3 to 12 carbon atoms is optionally substituted with a hydroxy group, an alkyl group having 1 or 2 carbon atoms, and/or an alkoxy group having 1 to 6 carbon atoms.

Examples of the alicyclic hydrocarbon group having 3 to 12 carbon atoms which contains an alicyclic structure having 3 to 6 carbon atoms and in which at least one carbon atom is substituted with an oxygen atom (-O-) include an epoxy group formed by substituting one carbon atom of an alicyclic hydrocarbon group having 3 carbon atoms with an oxygen atom, an oxetanyl ring formed by substituting one carbon atom of an alicyclic hydrocarbon group having 4 carbon atoms with an oxygen atom, a dioxolane ring formed by substituting two carbon atoms of an alicyclic hydrocarbon group having 5 carbon atoms with oxygen atoms, and a dioxane ring formed by substituting two carbon atoms of an alicyclic hydrocarbon group having 6 carbon atoms with oxygen atoms. It is noted here that the hydrogen atoms on these rings are each optionally substituted with an alkyl group having 1 or 2 carbon atoms. Specific examples of such groups include 3-ethyl-3-oxetanylmethyl acrylate, (2-methyl-2-ethyl-1,3-dioxolan-4-yl)methyl acrylate, and cyclic trimethylolpropane formal acrylate.

In the above-described alicyclic hydrocarbon group having 3 to 12 carbon atoms which contains an alicyclic structure having 3 to 6 carbon atoms and is, depending on the case, optionally substituted with a hydroxy group, an alkyl group having 1 or 2 carbon atoms and/or an alkoxy group having 1 to 6 carbon atoms, at least one hydrogen atom is optionally substituted with a halogen atom. When R₂ is such a group, the heat resistance of the piezoelectric material is likely to be improved.

In Formula (I), R₂ may represent (3) a phenyl group. At least one hydrogen atom on the phenyl ring of the phenyl group is optionally substituted with a hydroxy group, an alkyl group having 1 to 4 carbon atoms, and/or an alkoxy group having 1 to 6 carbon atoms. From the standpoint of improving the heat resistance of the piezoelectric material, a group in which at least one hydrogen atom on the phenyl ring, particularly a hydrogen atom at the para-position, is substituted with an alkyl group having 1 to 4 (preferably 1 or 2) carbon atoms and a hydrogen atom of this alkyl group having 1 to 4 carbon atoms is substituted with a halogen atom is preferred.

In the above-described phenyl group in which, depending on the case, at least one hydrogen atom on the phenyl ring is optionally substituted with a hydroxy group, an alkyl group having 1 to 4 carbon atoms and/or an alkoxy group having 1 to 6 carbon atoms, at least one hydrogen atom is optionally substituted with a halogen atom. When R₂ is such a group, the heat resistance of the piezoelectric material is likely to be improved.

When R₂ in Formula (I) represents (4) a phenylalkylene group which contains an alkylene group having 1 to 4 carbon atoms, at least one carbon atom of the alkylene group is optionally substituted with -O-, -N- or -S-, and at least one hydrogen atom on the phenyl ring is optionally substituted with a hydroxy group, an alkyl group having 1 to 4 carbon atoms, an alkoxy group having 1 to 6 carbon atoms, and/or a cyano group.

Examples of a phenylalkylene group in which at least one carbon atom of its alkylene group is substituted with-O- include groups represented by Formula (IV):

-((CH₂)ₚ-O-)_{q}-C₆H₅ (IV)

[wherein, p and q are each independently 2 or 3], and these groups in which at least one hydrogen atom of the alkylene moiety and the phenyl ring moiety is substituted with a hydroxy group, an alkyl group having 1 to 4 carbon atoms, an alkoxy group having 1 to 6 carbon atoms, and/or a cyano group. At least one hydrogen atom contained in each of the above-exemplified groups is optionally substituted with a halogen atom. When R₂ is any of the above-exemplified groups, the heat resistance of the piezoelectric material is likely to be improved.

In the above-described phenylalkylene group in which, depending on the case, at least one hydrogen atom on the alkylene group is optionally substituted with, for example, a hydroxy group, an alkyl group having 1 to 6 carbon atoms and/or an alkoxy group having 1 to 6 carbon atoms, and/or at least one hydrogen atom on the phenyl ring is optionally substituted with a hydroxy group, an alkyl group having 1 to 4 carbon atoms, an alkoxy group having 1 to 6 carbon atoms and/or a cyano group, at least one hydrogen atom is optionally substituted with a halogen atom. When R₂ is such a group, the heat resistance of the piezoelectric material is likely to be improved.

Preferred examples of the (meth)acrylic polymer contained in the piezoelectric material of the present invention include (meth)acrylic polymers which contain a structural unit derived from the (meth)acrylic monomer represented by Formula (I), wherein R₁ represents a halogen atom or an alkyl group having 1 to 3 carbon atoms in which at least one hydrogen atom is substituted with a halogen atom, and R₂ represents a linear or branched alkyl group having 1 to 10 (preferably 1 to 4, more preferably 1 to 2) carbon atoms, in which R₂: at least one carbon atom of the alkyl group is optionally substituted with -O-, -N-, or - S-; and at least one hydrogen atom of the alkyl group is optionally substituted with a hydroxy group, an alkyl group having 1 to 6 carbon atoms, and/or an alkoxy group having 1 to 6 carbon atoms.

Other preferred examples of the (meth)acrylic polymer contained in the piezoelectric material of the present invention include (meth)acrylic polymers which contain a structural unit derived from the (meth)acrylic monomer represented by Formula (I), wherein R₁ represents a hydrogen atom or an alkyl group having 1 to 3 carbon atoms, and R₂ represents a linear or branched alkyl group having 1 to 10 (preferably 1 to 4, more preferably 1 to 2) carbon atoms, in which R₂: at least one carbon atom of the alkyl group is optionally substituted with -O-, -N-, or -S-; at least one hydrogen atom of the alkyl group is optionally substituted with a hydroxy group, an alkyl group having 1 or 2 carbon atoms, and/or an alkoxy group having 1 to 6 carbon atoms; and at least one hydrogen atom (preferably 2 or more hydrogen atoms, more preferably 3 or more hydrogen atoms) is substituted with a halogen atom. More specific examples of these (meth)acrylic polymers include compounds wherein R₁ represents a hydrogen atom or an alkyl group having 1 to 3 carbon atoms, and R₂ represents a linear or branched alkyl group having 1 to 10 (preferably 1 to 4, more preferably 1 to 3) carbon atoms, in which R₂: at least one carbon atom of the alkyl group is optionally substituted with -O-, -N-, or -S-; and at least one hydrogen atom of the alkyl group is substituted with an alkyl group having 1 or 2 carbon atoms in which at least one hydrogen atom is substituted with a halogen atom. Examples of such compounds include 3,3,3-trifluoropropyl (meth)acrylate,3,3,3-trichloropropyl (meth)acrylate, 4,4,4-trifluorobutyl (meth)acrylate, 4,4,4-trichlorobutyl (meth)acrylate, 2,2-difluoroethyl (meth)acrylate, and 2,2-dichloroethyl (meth)acrylate.

Other preferred examples of the (meth)acrylic polymer contained in the piezoelectric material of the present invention also include (meth)acrylic polymers which contain a structural unit derived from the (meth)acrylic monomer represented by Formula (I), wherein R₁ represents a hydrogen atom or an alkyl group having 1 to 3 carbon atoms, and R₂ represents an alicyclic hydrocarbon group having 3 to 12 carbon atoms which contains an alicyclic structure having 3 to 6 carbon atoms, in which R₂: at least one carbon atom of the alicyclic hydrocarbon group is optionally substituted with -O-, -N-, or -S-; at least one hydrogen atom of the alicyclic hydrocarbon group is optionally substituted with a hydroxy group, an alkyl group having 1 or 2 carbon atoms, and/or an alkoxy group having 1 to 6 carbon atoms; and at least one hydrogen atom (preferably 2 or more hydrogen atoms, more preferably 3 or more hydrogen atoms) is substituted with a halogen atom. When the piezoelectric material contains any of these (meth)acrylic polymers, not only the remnant polarization of the piezoelectric material is likely to be enhanced, but also the heat resistance is likely to be improved. More specific examples of these (meth)acrylic polymers include compounds in which R₁ represents a hydrogen atom or an alkyl group having 1 to 3 carbon atoms, and R₂ represents an alicyclic hydrocarbon group having 3 to 12 carbon atoms which contains an alicyclic structure having 3 to 6 carbon atoms, in which R₂: at least one carbon atom of the alicyclic hydrocarbon group is optionally substituted with -O-, -N-, or -S-; and at least one hydrogen atom of the alicyclic hydrocarbon group is substituted with an alkyl group having 1 or 2 carbon atoms in which at least one hydrogen atom is substituted with a halogen atom. Examples of such compounds include 4-(trifluoromethyl)cyclohexyl (meth)acrylate and 4-(trichloromethyl)cyclohexyl (meth)acrylate.

Specific examples of the (meth)acrylic polymer contained in the piezoelectric material of the present invention include, but not limited to: 3,3,3-trifluoropropyl (meth)acrylate, 3,3,3-trichloropropyl (meth)acrylate, 4,4,4-trifluorobutyl (meth)acrylate, 4,4,4-trichlorobutyl (meth)acrylate, 2,2-difluoroethyl (meth)acrylate, 2,2-dichloroethyl (meth)acrylate, 4-(trifluoromethyl)cyclohexyl (meth)acrylate, and 4-(trichloromethyl)cyclohexyl (meth)acrylate.

The (meth)acrylic polymer contained in the piezoelectric material of the present invention may contain only a structural unit derived from one (meth)acrylic monomer represented by Formula (I), or may contain structural units derived from two or more (meth)acrylic monomers represented by Formula (I). Further, the (meth)acrylic polymer contained in the piezoelectric material of the present invention may contain a structural unit derived from at least one other monomer within a range that does not impair the properties of the piezoelectric material of the present invention. In other words, the (meth)acrylic polymer contained in the piezoelectric material of the present invention may be a homopolymer of the (meth)acrylic monomer represented by Formula (I), a copolymer of two or more (meth)acrylic monomers represented by Formula (I), or a copolymer of at least one (meth)acrylic monomer represented by Formula (I) and at least one other monomer.

Examples of the other monomer copolymerizable with the (meth)acrylic monomer represented by Formula (I) include carboxyl group-containing monomers, carboxylic acid alkyl ester-based monomers other than a (meth)acrylic monomer that gives a structural unit represented by Formula (I), amide group-containing monomers, aryl group-containing monomers, styrene-based monomers, nitrogen atom-containing monomers, fatty acid vinyl ester-based monomers, and betaine monomers.

Examples of the carboxyl group-containing monomers include (meth)acrylic acid, maleic acid, fumaric acid, citraconic acid, mesaconic acid, itaconic acid, and crotonic acid.

Examples of the carboxylic acid alkyl ester-based monomers other than a (meth)acrylic monomer that gives a structural unit represented by Formula (I) include: alkyl acrylates whose alkyl groups have 11 to 20 carbon atoms, such as dodecyl (meth)acrylate and stearyl (meth)acrylate; and alkyl itaconates whose alkyl groups have 1 to 4 carbon atoms, such as methyl itaconate and ethyl itaconate.

Examples of the amide group-containing monomers include alkyl (meth)acrylamides whose alkyl groups have 1 to 8 carbon atoms, such as N-methyl (meth)acrylamide, N-ethyl (meth)acrylamide, N-propyl (meth)acrylamide, N-isopropyl (meth)acrylamide, N-tert-butyl (meth)acrylamide, N-octyl (meth)acrylamide, N,N-dimethyl (meth)acrylamide, and N,N-diethyl (meth)acrylamide.

Examples of the aryl group-containing monomers include aryl (meth)acrylates whose aryl groups have 6 to 12 carbon atoms, such as benzyl (meth)acrylate.

Examples of the styrene-based monomers include styrene and α-methylstyrene.

Examples of the nitrogen atom-containing monomers include N-vinylpyrrolidone and N-vinylcaprolactam.

Examples of the fatty acid vinyl ester-based monomers include vinyl acetate and vinyl propionate.

Examples of the betaine monomers include sulfobetaine monomers, for example, *N*-(meth)acryloyloxyalkyl-*N,N-*dimethyl ammonium alkyl-*α*-sulfobetaines, such as *N-*acryloyloxymethyl-*N,N*-dimethyl ammonium methyl-*α-*sulfobetaine, *N*-methacryloyloxymethyl-*N,N*-dimethyl ammonium methyl-*α*-sulfobetaine, *N*-acryloyloxymethyl-*N,N*-dimethyl ammonium ethyl-*α*-sulfobetaine, *N*-methacryloyloxymethyl-*N,N-*dimethyl ammonium ethyl-*α*-sulfobetaine, *N-*acryloyloxymethyl-*N,N*-dimethyl ammonium propyl-*α-*sulfobetaine, *N*-methacryloyloxymethyl-*N,N*-dimethyl ammonium propyl-*α*-sulfobetaine, *N*-acryloyloxymethyl-*N,N*-dimethyl ammonium butyl-*α*-sulfobetaine, *N*-methacryloyloxymethyl-*N,N-*dimethyl ammonium butyl-*α*-sulfobetaine, *N*-acryloyloxyethyl-*N,N*-dimethyl ammonium methyl-*α*-sulfobetaine, *N-*methacryloyloxyethyl-*N,N*-dimethyl ammonium methyl-*α-*sulfobetaine, *N*-acryloyloxyethyl-*N,N*-dimethyl ammonium ethyl-*α*-sulfobetaine, N-methacryloyloxyethyl-*N,N*-dimethyl ammonium ethyl-*α*-sulfobetaine, *N*-acryloyloxyethyl-*N,N-*dimethyl ammonium propyl-*α*-sulfobetaine, *N-*methacryloyloxyethyl-*N,N*-dimethyl ammonium propyl-*α-*sulfobetaine, *N*-acryloyloxyethyl-*N,N*-dimethyl ammonium butyl-*α*-sulfobetaine, *N*-methacryloyloxyethyl-*N,N*-dimethyl ammonium butyl-*α*-sulfobetaine, *N*-acryloyloxypropyl-*N,N-*dimethyl ammonium methyl-*α*-sulfobetaine, *N-*methacryloyloxypropyl-*N,N*-dimethyl ammonium methyl-*α-*sulfobetaine, *N*-acryloyloxypropyl-*N,N*-dimethyl ammonium ethyl-*α*-sulfobetaine, *N*-methacryloyloxypropyl-*N,N*-dimethyl ammonium ethyl-*α*-sulfobetaine, *N*-acryloyloxypropyl-*N,N-*dimethyl ammonium propyl-*α*-sulfobetaine, *N-*methacryloyloxypropyl-*N,N-*dimethyl ammonium propyl-*α-*sulfobetaine, *N*-acryloyloxypropyl-*N,N*-dimethyl ammonium butyl-*α*-sulfobetaine, *N*-methacryloyloxypropyl-*N,N*-dimethyl ammonium butyl-*α*-sulfobetaine, *N*-acryloyloxybutyl-*N,N-*dimethyl ammonium methyl-*α*-sulfobetaine, *N-*methacryloyloxybutyl-*N,N*-dimethyl ammonium methyl-*α-*sulfobetain, *N*-acryloyloxybutyl-*N,N*-dimethyl ammonium ethyl-*α*-sulfobetaine, *N*-methacryloyloxybutyl-*N,N*-dimethyl ammonium ethyl-*α*-sulfobetaine, *N*-acryloyloxybutyl-*N,N-*dimethyl ammonium propyl-*α*-sulfobetaine, *N-*methacryloyloxybutyl-*N,N-*dimethyl ammonium propyl-*α-*sulfobetaine, *N*-acryloyloxybutyl-*N,N*-dimethyl ammonium butyl-*α*-sulfobetaine, *N*-methacryloyloxybutyl-*N,N*-dimethyl ammonium butyl-*α*-sulfobetaine.

In monomer components used for the production of the (meth)acrylic polymer, from the standpoint of enhancing the remnant polarization of the piezoelectric material and improving the piezoelectric properties, the content ratio of the (meth)acrylic monomer represented by Formula (I) is preferably 60% by mass or higher, more preferably 70% by mass or higher, still more preferably 80% by mass or higher, particularly preferably 90% by mass or higher, particularly more preferably 93% by mass or higher, most preferably 95% by mass or higher, with respect to the amount of all monomer components used for the production of the (meth)acrylic polymer. An upper limit of this content ratio is not particularly restricted as long as it is not higher than 100% by mass, and the upper limit may be 99% by mass or lower, 98% by mass or lower, or 97% by mass or lower. When the monomer components used for the production of the (meth)acrylic polymer contain other monomer copolymerizable with the (meth)acrylic monomer represented by Formula (I), from the standpoint of enhancing the remnant polarization of the piezoelectric material and improving the piezoelectric properties, the content ratio of the other monomer is preferably 40% by mass or lower, more preferably 30% by mass or lower, still more preferably 20% by mass or lower, particularly preferably 10% by mass or lower, particularly more preferably 7% by mass or lower, most preferably 5% by mass or lower, with respect to the amount of all monomer components used for the production of the (meth)acrylic polymer. A lower limit of this content ratio is not particularly restricted, and may be 1% by mass or higher, 2% by mass or higher, or 3% by mass or higher, with respect to the mass of all monomer components.

In the monomer components used for the production of the (meth)acrylic polymer, an appropriate amount of a cross-linkable monomer may be contained within a range that does not hinder the object of the present invention. As described above, the (meth)acrylic polymer contained in the piezoelectric material of the present invention is a polymer containing a structural unit derived from the above-described (meth)acrylic monomer represented by Formula (I). The cross-linkable monomer is (1) contained as a structural unit in the main chain of the polymer containing a structural unit derived from the (meth)acrylic monomer represented by Formula (I) and binds (cross-links) the polymer containing a structural unit derived from the (meth)acrylic monomer represented by Formula (I) with one another, and/or (2) not contained in the main chain of the polymer containing a structural unit derived from the (meth)acrylic monomer represented by Formula (I) but is bound to a side chain of the polymer containing a structural unit derived from the (meth)acrylic monomer represented by Formula (I) and binds (cross-links) the polymer containing a structural unit derived from the acrylic monomer represented by Formula (I) with one another. In both of these modes (1) and (2), since the (meth)acrylic polymer contains a structural unit derived from the cross-linkable monomer, plural polymers containing a structural unit derived from the (meth)acrylic monomer represented by Formula (I) are bound, and a single polymer having a larger molecular weight is thereby formed.

Examples of the cross-linkable monomer include polyfunctional monomers, for example: (meth)acrylamide compounds having two or more, preferably two (meth)acryloyl groups, for example, alkylene bis(meth)acrylamides whose alkylene groups have 1 to 4 carbon atoms, such as methylene-bis-acrylamide and methylene-bis-methacrylamide; (meth)acrylate compounds having two or more, preferably two or three (meth)acryloyl groups, such as ethylene di(meth)acrylate, ethylene glycol di(meth)acrylate, diethylene glycol di(meth)acrylate, propylene glycol di(meth)acrylate, triethylene glycol di(meth)acrylate, 1,4-butanediol di(meth)acrylate, 1,6-hexanediol di(meth)acrylate, 1,9-nonanediol di(meth)acrylate, 2-n-butyl-2-ethyl-1,3-propanediol di(meth)acrylate, triethylene glycol di(meth)acrylate, tripropylene glycol di(meth)acrylate, tetraethylene glycol di(meth)acrylate, trimethylolpropane tri(meth)acrylate, and pentaerythritol tri(meth)acrylate; amine compounds having two or more, preferably two or three carbon-carbon double bonds, such as diallylamine and triallylamine; and aromatic compounds having two or more, preferably two or three carbon-carbon double bonds, such as divinylbenzene and diallylbenzene; however, the present invention is not restricted only to the above examples. These cross-linkable monomers may be used singly, or in combination of two or more thereof.

The weight-average molecular weight of the (meth)acrylic polymer contained in the piezoelectric material of the present invention is preferably 10,000 or higher, more preferably 50,000 or higher, still more preferably 100,000 or higher, particularly preferably 150,000 or higher. When the weight-average molecular weight of the (meth)acrylic polymer is not less than the above-described lower limit value, the strength and the durability of the piezoelectric material are likely to be improved. Meanwhile, from the standpoint of the ease of producing the (meth)acrylic polymer, the weight-average molecular weight of the (meth)acrylic polymer is preferably 2,000,000 or less, more preferably 1,500,000 or less, still more preferably 1,000,000 or less, particularly preferably 750,000 or less. The weight-average molecular weight of the (meth)acrylic polymer can be measured by gel permeation chromatography. The details of the measurement conditions and the like are as described below in the section of Examples.

### (Production Method of (Meth)acrylic Polymer)

The (meth)acrylic polymer contained in the piezoelectric material of the present invention can be obtained by, for example, polymerizing monomer components.

Examples of a method of polymerizing monomer components include a bulk polymerization method, a solution polymerization method, an emulsion polymerization method, and a suspension polymerization method; however, the present invention is not restricted only to the above examples. Among these polymerization methods, from the standpoint of the productivity of the (meth)acrylic polymer, a bulk polymerization method and a solution polymerization method are preferred.

A solvent is used when polymerizing monomer components by a solution polymerization method. The solvent is preferably a nonaqueous organic solvent. Examples of the nonaqueous organic solvent include: hydrocarbon-based organic solvents, such as hexane, heptane, octane, isooctane, decane, and liquid paraffin; ether-based organic solvents, such as dimethyl ether, diethyl ether, and tetrahydrofuran; ketone-based organic solvents, such as acetone and methyl ethyl ketone; ester-based organic solvents, such as methyl acetate, ethyl acetate, butyl acetate, and *γ*-butyrolactone; chloride-based organic solvents, such as methylene chloride, chloroform, and carbon tetrachloride; dimethylformamide; diethylformamide; dimethyl sulfoxide; and dioxane; however, the present invention is not restricted only to the above examples. These solvents may be used singly, or in combination of two or more thereof. The amount of a solvent varies depending on the type of the solvent and thus cannot be generally defined; however, usually, it is preferably about 100 to 1,000 parts by mass per 100 parts by mass of monomer components.

A polymerization initiator can be used in the polymerization of monomer components. Examples of the polymerization initiator include photopolymerization initiators and thermal polymerization initiators. Among these polymerization initiators, from the standpoint of not leaving any thermal history in the resulting (meth)acrylic elastomer, a photopolymerization initiator is preferred. Examples of the polymerization initiator include 2,2'-azobisisobutyronitrile, methyl azoisobutyrate, azobisdimethylvaleronitrile, benzoyl peroxide, potassium persulfate, ammonium persulfate, benzophenone derivatives, phosphine oxide derivatives, benzoketone derivatives, phenyl thioether derivatives, azide derivatives, diazo derivatives, and disulfide derivatives. Two or more of these polymerization initiators may be used as desired.

Examples of the photopolymerization initiators include: photoradical polymerization initiators, such as 2,4,6-trimethylbenzoyldiphenyl phosphine oxide, 2,2'-bis(*o-*chlorophenyl)-4,4',5,5'-tetraphenyl-1,1'-biimidazole, 2,4,6-tris(trichloromethyl)-1,3,5-triazine, 2,4-bis(trichloromethyl)-6-(*p*-methoxyphenylvinyl)-1,3,5-triazine, diphenyl iodonium tetrafluoroborate, diphenyl iodonium hexafluorophosphate, 4,4'-di-*tert*-butyldiphenyl iodonium tetrafluoroborate, 4-diethylaminophenylbenzene diazonium hexafluorophosphate, benzoin, 2-hydroxy-2-methyl-1-phenylpropan-2-one, benzophenone, thioxanthone, 2,4,6-trimethylbenzoyldiphenylacyl phosphine oxide, triphenylbutylborate tetraethyl ammonium, diphenyl-4-phenylthiophenyl sulfonium hexafluorophosphate, 2,2-dimethoxy-1,2-diphenylethan-1-one, phenylglyoxylic acid methyl ester, 2-methyl-1-[4-(methylthio)phenyl]-2-morpholinopropan-1-one, bis(2,4,6-trimethylbenzoyl)-phenyl phosphine oxide, 1,2-octanedione, 1-[4-(phenylthio)-2-(*o-*benzoyloxime)], and bis(η5-2,4-cyclopentadien-1-yl)bis[2,6-difluoro-3-(1H-pyrrol-1-yl)phenyl titanium]; and photocationic ring-opening polymerization initiators, such as 2,4,6-tris(trichloromethyl)-1,3,5-triazine, 2,4-bis(trichloromethyl)-6-(*p*-methoxyphenylvinyl)-1,3,5-triazine, diphenyl iodonium tetrafluoroborate, 4,4'-di-*tert*-butyldiphenyl iodonium tetrafluoroborate, 4-diethylaminophenylbenzene diazonium hexafluorophosphate, and diphenyl-4-phenylthiophenyl sulfonium hexafluorophosphate; however, the present invention is not restricted only to the above examples. These photopolymerization initiators may be used singly, or in combination of two or more thereof.

Examples of the thermal polymerization initiators include: azo-based polymerization initiators, such as dimethyl-2,2'-azobis(2-methyl propionate), 2,2'-azobisisobutyronitrile (AIBN), dimethyl 2,2'-azobisisobutyrate, and azobisdimethylvaleronitrile; and peroxide-based polymerization initiators, such as benzoyl peroxide, potassium persulfate, and ammonium persulfate; however, the present invention is not restricted only to the above examples. These polymerization initiators may be used singly, or in combination of two or more thereof.

The amount of a polymerization initiator varies depending on the type and the like of the polymerization initiator and thus cannot be generally defined; however, usually, it is preferably about 0.01 to 20 parts by mass per 100 parts by mass of monomer components.

In the polymerization of monomer components, a chain transfer agent can be used for adjusting the molecular weight of the resulting (meth)acrylic polymer. Examples of the chain transfer agent include: thiol group-containing compounds, such as lauryl mercaptan, dodecyl mercaptan, and thioglycerol; and inorganic salts, such as sodium hypophosphite and sodium bisulfate; however, the present invention is not restricted only to the above examples. These chain transfer agents may be used singly, or in combination of two or more thereof. The amount of a chain transfer agent varies depending on the type and the like of the chain transfer agent and thus cannot be generally defined; however, usually, it is preferably about 0.01 to 10 parts by mass per 100 parts by mass of monomer components.

The atmosphere in which monomer components are polymerized is not particularly restricted, and the polymerization may be performed in the air, or in an inert gas atmosphere such as nitrogen gas or argon gas.

The temperature at which monomer components are polymerized is not particularly restricted and, usually, it is preferably about 5 to 100°C. The time required for polymerizing the monomer components varies depending on the polymerization conditions, and it cannot be generally defined and thus may be set arbitrarily; however, it is usually about 1 to 20 hours.

A polymerization reaction can be terminated at any point when the amount of the remaining monomer components is 20% by mass or less. The amount of the remaining monomer components can be determined by, for example, gel permeation chromatography.

The (meth)acrylic polymer contained in the piezoelectric material of the present invention can be obtained by polymerizing monomer components in the above-described manner.

### (Vinylidene Fluoride/Trifluoroethylene Copolymer)

The vinylidene fluoride/trifluoroethylene copolymer contained in the piezoelectric material of the present invention is a copolymer which contains a structural unit derived from vinylidene fluoride and a structural unit derived from trifluoroethylene. In the vinylidene fluoride/trifluoroethylene copolymer, from the standpoint of enhancing the remnant polarization of the piezoelectric material and obtaining the piezoelectric material with good heat resistance and deformation resistance, the amount of the structural unit derived from vinylidene fluoride is preferably not less than 55% by mole, more preferably not less than 70% by mole, still more preferably not less than 75% by mole, and may be 80% by mole or greater, or 85% by mole or greater, based on the amount of all structural units. Further, from the standpoint of enhancing the remnant polarization of the piezoelectric material and improving the piezoelectric properties, the amount of the structural unit derived from vinylidene fluoride is preferably 90% by mole or less, more preferably 86% by mole or less, based on the amount of all structural units.

In the vinylidene fluoride/trifluoroethylene copolymer, from the standpoint of enhancing the remnant polarization of the piezoelectric material and improving the piezoelectric properties, the amount of the structural unit derived from trifluoroethylene is preferably not less than 10% by mole, more preferably not less than 14% by mole, based on the amount of all structural units. Further, from the standpoint of obtaining the piezoelectric material with good heat resistance, the amount of the structural unit derived from trifluoroethylene is preferably 45% by mole or less, more preferably 30% by mole or less, still more preferably 25% by mole or less, particularly preferably 20% by mole or less, based on the amount of all structural units.

The piezoelectric material of the present invention may contain a single kind of vinylidene fluoride/trifluoroethylene copolymer, or may contain two or more kinds of vinylidene fluoride/trifluoroethylene copolymers.

The weight-average molecular weight of the vinylidene fluoride/trifluoroethylene copolymer contained in the piezoelectric material of the present invention is not particularly restricted; however, from the standpoint of obtaining the piezoelectric material with large remnant polarization, it is preferably 100,000 or higher, more preferably 300,000 or higher, still more preferably 500,000 or higher, yet still more preferably 550,000 or higher, particularly preferably 600,000 or higher. An upper limit of the weight-average molecular weight is not particularly restricted, and it is, for example, about 2,000,000 or less. The weight-average molecular weight can be determined by any known method.

In the vinylidene fluoride/trifluoroethylene copolymer contained in the piezoelectric material of the present invention, in addition to the structural unit derived from vinylidene fluoride and the structural unit derived from trifluoroethylene, a structural unit derived from other monomer copolymerizable with vinylidene fluoride and/or trifluoroethylene may be incorporated within a range that does not impair the effects of the present invention. Examples of this other monomer include those monomers that are exemplified above as other monomers copolymerizable with the (meth)acrylic monomer in relation to the (meth)acrylic polymer. From the standpoint of obtaining the piezoelectric material with excellent heat resistance and piezoelectric properties, the content ratio of the structural unit derived from vinylidene fluoride and the structural unit derived from trifluoroethylene in the vinylidene fluoride/trifluoroethylene copolymer is preferably 80% by mass or higher, more preferably 85% by mass or higher, still more preferably 90% by mass or higher, particularly preferably 93% by mass or higher, most preferably 95% by mass or higher, and the content ratio of the structural unit derived from the other monomer copolymerizable with vinylidene fluoride and/or trifluoroethylene is preferably 20% by mass or lower, more preferably 15% by mass or lower, still more preferably 10% by mass or lower, particularly preferably 7% by mass or lower, most preferably 5% by mass or lower. Further, in the vinylidene fluoride/trifluoroethylene copolymer, the content ratio of the structural unit derived from vinylidene fluoride and the structural unit derived from trifluoroethylene may be 100% by mass or lower, 99% by mass or lower, 98% by mass or lower, or 97% by mass or lower, and the content ratio of the structural unit derived from the other monomer copolymerizable with vinylidene fluoride and/or trifluoroethylene may be 1% by mass or higher, 2% by mass or higher, or 3% by mass or higher.

As the vinylidene fluoride/trifluoroethylene copolymer contained in the piezoelectric material of the present invention, for example, a vinylidene fluoride/trifluoroethylene copolymer having the formulation and the molecular weight that are shown in Patent Document 1 may be used, or a commercially available vinylidene fluoride/trifluoroethylene copolymer may be used. Examples of the commercially available vinylidene fluoride/trifluoroethylene copolymer include "FC20", "FC25" and "FC30", which are manufactured by Piezotech LLC.

### (Composition for Piezoelectric Material and Piezoelectric Material)

From the standpoint of enhancing the remnant polarization of the piezoelectric material and improving the piezoelectric properties, the amount of the vinylidene fluoride/trifluoroethylene copolymer contained in the piezoelectric material of the present invention is preferably not less than 40% by mass, more preferably not less than 50% by mass, still more preferably not less than 60% by mass, yet still more preferably not less than 65% by mass, yet still more preferably not less than 70% by mass, particularly preferably not less than 75% by mass, and may be 80% by mass or greater, or 85% by mass or greater, based on the whole piezoelectric material. Further, from the standpoint of enhancing the remnant polarization of the piezoelectric material as well as the standpoint of allowing other functions of the above-described specific (meth)acrylic polymer (e.g., improvement in the heat resistance and the like of the piezoelectric material) to be exerted, the amount of the vinylidene fluoride/trifluoroethylene copolymer contained in the piezoelectric material of the present invention is preferably 99% by mass or less, more preferably 98% by mass or less, still more preferably 95% by mass or less, particularly preferably 90% by mass or less, and may be 85% by mass or less, or 80% by mass or less.

From the standpoint of enhancing the remnant polarization of the piezoelectric material as well as the standpoint of allowing other functions of the above-described specific (meth)acrylic polymer to be exerted, the amount of the (meth)acrylic polymer contained in the piezoelectric material of the present invention is preferably not less than 1% by mass, more preferably not less than 2% by mass, still more preferably not less than 5% by mass, particularly preferably not less than 10% by mass, and may be 15% by mass or greater, or 20% by mass or greater, based on the whole piezoelectric material. Further, from the standpoint of enhancing the remnant polarization of the piezoelectric material and improving the piezoelectric properties, the amount of the (meth)acrylic polymer contained in the piezoelectric material of the present invention is preferably 60% by mass or less, more preferably 50% by mass or less, still more preferably 40% by mass or less, yet still more preferably 35% by mass or less, yet still more preferably 30% by mass or less, particularly preferably 25% by mass or less, and may be 20% by mass or less, or 15% by mass or less.

The piezoelectric material of the present invention also encompasses a mode of containing a material other than the vinylidene fluoride/trifluoroethylene copolymer and the specific (meth)acrylic polymer (which material is hereinafter referred to as "other material"). Examples of the other material include, but not limited to: copolymers and elastomers other than the vinylidene fluoride/trifluoroethylene copolymer and the specific (meth)acrylic polymer; additives, such as antioxidants and ultraviolet absorbers; thermally conductive fillers; and electrically conductive fillers.

The amount of the vinylidene fluoride/trifluoroethylene copolymer contained in the piezoelectric material of the present invention is preferably not less than 40% by mass, more preferably not less than 50% by mass, still more preferably not less than 60% by mass, yet still more preferably not less than 65% by mass, yet still more preferably not less than 70% by mass, particularly preferably not less than 75% by mass, and may be 80% by mass or greater, or 85% by mass or greater, based on a total weight of the vinylidene fluoride/trifluoroethylene copolymer and the (meth)acrylic polymer that are contained in the piezoelectric material of the present invention. Further, the amount of the vinylidene fluoride/trifluoroethylene copolymer contained in the piezoelectric material of the present invention is preferably 99% by mass or less, more preferably 98% by mass or less, still more preferably 95% by mass or less, particularly preferably 90% by mass or less, and may be 85% by mass or less or 80% by mass or less, based on a total weight of the vinylidene fluoride/trifluoroethylene copolymer and the (meth)acrylic polymer that are contained in the piezoelectric material of the present invention. When the amount of the vinylidene fluoride/trifluoroethylene copolymer is not less than the above-described lower limit, the remnant polarization of the piezoelectric material is likely to be enhanced, and the piezoelectric properties are thus likely to be improved. Meanwhile, when the amount of the vinylidene fluoride/trifluoroethylene copolymer is not greater than the above-described upper limit, not only the remnant polarization of the piezoelectric material is likely to be enhanced, but also other functions of the specific (meth)acrylic polymer (e.g., improvement in the heat resistance, elongation, and/or flexibility of the piezoelectric material) are likely to be exerted.

The structure and the amount of the vinylidene fluoride/trifluoroethylene copolymer and those of the specific (meth)acrylic polymer in the piezoelectric material can be analyzed using, for example, but not limited to: an infrared (IR) spectrometer or a nuclear magnetic resonance (NMR) apparatus. The amounts of these constituents may be calculated from the usage ratios of their raw materials. Accordingly, the structures and the amounts of the vinylidene fluoride/trifluoroethylene copolymer and the (meth)acrylic polymer that constitute the piezoelectric material may be analyzed by determining the structures of the vinylidene fluoride/trifluoroethylene copolymer and the specific (meth)acrylic polymer that are contained in the piezoelectric material, subsequently fractionating the respective constituents from the piezoelectric material by a known method or preparing the specific (meth)acrylic polymer having the same structure, and then performing an analysis by the above-described analysis method or the like. The amount of halogen atoms contained in the (meth)acrylic polymer, the amount of halogen atoms contained in the structural unit derived from the (meth)acrylic monomer, and the like can also be determined in the same manner.

A method of producing the piezoelectric material of the present invention is not particularly restricted, and the piezoelectric material of the present invention may be produced by, for example, applying and drying a solution that contains the vinylidene fluoride/trifluoroethylene copolymer, the specific (meth)acrylic polymer and a solvent, and subsequently performing a heat treatment to crystallize the vinylidene fluoride/trifluoroethylene copolymer and thereby allow piezoelectric properties to be exerted. It is noted here that the drying and the heat treatment may be performed simultaneously. As another example, the piezoelectric material of the present invention may be produced by a method of producing a piezoelectric material, the method including the steps of: mixing the vinylidene fluoride/trifluoroethylene copolymer with the monomers constituting the specific (meth)acrylic polymer and, as required, a solvent; polymerizing the monomers to obtain the specific (meth)acrylic polymer; and crystallizing the vinylidene fluoride/trifluoroethylene copolymer and thereby allowing piezoelectric properties to be exerted. As yet another example, the piezoelectric material of the present invention may be produced by a method of producing a piezoelectric material, the method including the steps of: mixing the specific (meth)acrylic polymer with the monomers constituting the vinylidene fluoride/trifluoroethylene copolymer and, as required, a solvent; polymerizing the monomers to obtain the vinylidene fluoride/trifluoroethylene copolymer; and crystallizing the thus obtained vinylidene fluoride/trifluoroethylene copolymer and thereby allowing piezoelectric properties to be exerted. The solution for the production of the piezoelectric material, which contains the vinylidene fluoride/trifluoroethylene copolymer, the specific (meth)acrylic polymer and a solvent, is hereinafter also referred to as "composition for a piezoelectric material". The composition for a piezoelectric material also encompasses a composition which contains either one of the vinylidene fluoride/trifluoroethylene copolymer and the specific (meth)acrylic polymer, and the other in the state of its constituting monomer(s). The present invention also provides such a composition for a piezoelectric material. It is noted here that, in the present specification, the descriptions relating to the (meth)acrylic polymer and the vinylidene fluoride/trifluoroethylene copolymer that are contained in the piezoelectric material of the present invention also apply in the same manner to the (meth)acrylic polymer and the vinylidene fluoride/trifluoroethylene copolymer that are contained in the composition for a piezoelectric material according to the present invention.

The solvent that may be contained in the composition for a piezoelectric material is not particularly restricted as long as it can dissolve the vinylidene fluoride/trifluoroethylene copolymer and the specific (meth)acrylic polymer, and examples of the solvent include N,N-dimethylformamide, N,N-dimethylacetamide, 1-methyl-2-pyrrolidone, and diethyl carbonate.

The composition for a piezoelectric material according to the present invention may be produced by, for example, but not particularly limited to: mixing the vinylidene fluoride/trifluoroethylene copolymer, the specific (meth)acrylic polymer, and optionally a solvent with heating as required, and thereby dissolving the vinylidene fluoride/trifluoroethylene copolymer and the (meth)acrylic polymer in the solvent. Alternatively, the composition for a piezoelectric material may be produced by mixing the vinylidene fluoride/trifluoroethylene copolymer, the monomers constituting the specific (meth)acrylic polymer, and a solvent with heating as required. In this case, a composition containing the specific (meth)acrylic polymer, which is obtained after polymerizing the monomers constituting the specific (meth)acrylic polymer that are contained in the composition for a piezoelectric material, is also the composition for a piezoelectric material according to the present invention. A composition for a piezoelectric material, which contains the monomers constituting the vinylidene fluoride/trifluoroethylene copolymer along with the specific (meth)acrylic polymer, can also be produced in the same manner.

Subsequently, the composition for a piezoelectric material according to the present invention is applied onto a substrate and, as required, the monomers constituting the specific (meth)acrylic polymer or the monomers constituting the vinylidene fluoride/trifluoroethylene copolymer are polymerized, after which the composition is dried and crystallized by a heat treatment so as to exert piezoelectric properties, whereby the piezoelectric material of the present invention can be produced. For example, when the piezoelectric material of the present invention is a piezoelectric film, the composition for a piezoelectric material according to the present invention may be applied onto the surface of a substrate. For example, when the piezoelectric material of the present invention is a piezoelectric wire, the composition for a piezoelectric material according to the present invention may be applied onto a conductive wire such as a copper wire, for example, a single wire made of a conductive material, by a known method.

A method of drying the thus applied composition for a piezoelectric material according to the present invention is also not particularly restricted, and the composition may be dried by heating under the condition of atmospheric pressure, reduced pressure or the like at a temperature at which the solvent is evaporated. For example, the drying is preferably performed at a temperature of 15 to 80°C.

In the production of the piezoelectric material of the present invention, the temperature of the heat treatment is preferably not lower than the Curie point but not higher than the melting point of the vinylidene fluoride/trifluoroethylene copolymer. The heating time is preferably 30 minutes or longer, more preferably 2 hours or longer. By performing such a heat treatment, the vinylidene fluoride/trifluoroethylene copolymer can be crystallized to exert piezoelectric properties.

The piezoelectric material of the present invention may be a piezoelectric film, a piezoelectric wire, or a piezoelectric block (aggregate). The piezoelectric material of the present invention exhibits a large remnant polarization and thus has a large storable electrical energy per unit volume; therefore, it can be utilized in, for example, members of sensors and the like.

In one preferred mode of the present invention, the piezoelectric material of the present invention not only has a large remnant polarization but also exhibits excellent heat resistance. From the standpoint of taking advantage of these characteristic features of the piezoelectric material of the present invention in this mode, the piezoelectric material is particularly suitable for members of sensors, such as touch sensors, acceleration sensors, vibration sensors and ultrasonic sensors, as well as members of strain gauges, members of transducers, and the like. As a method of evaluating the heat resistance of the piezoelectric material, for example, a method of measuring the 1% weight reduction temperature using a thermogravimetric-differential thermal analyzer may be employed. In this evaluation method, a piezoelectric material having a 1% weight reduction temperature of preferably 120°C or higher, more preferably 150°C or higher, still more preferably 200°C or higher, is said to have particularly excellent heat resistance.

From the standpoint of obtaining sufficient piezoelectric properties, the remnant polarization of the piezoelectric material of the present invention is preferably 100 mC/m² or higher, more preferably 105 mC/m² or higher, still more preferably 110 mC/m² or higher, yet still more preferably 120 mC/m² or higher, yet still more preferably 140 mC/m² or higher, yet still more preferably 150 mC/m² or higher, yet still more preferably 170 mC/m² or higher, yet still more preferably 175 mC/m² or higher. The higher the remnant polarization, the more preferred it is. An upper limit of the remnant polarization is not particularly restricted and may be, for example, 300 mC/m² or lower. The remnant polarization may be measured under the condition of applying a triangular wave alternating current at, for example, a voltage magnitude of 200 MV/m and a frequency of 0.01 Hz or 0.1 Hz and, for example, the measurement method described below in the section of Examples may be employed.

From the standpoint of obtaining sufficient piezoelectric properties, the piezoelectric constant d₃₃ of the piezoelectric material of the present invention is preferably of 24.5 pC/N or higher, more preferably 25 pC/N or higher. The method of measuring the piezoelectric constant d₃₃ is as described below in the section of Examples.

### EXAMPLES

The present invention will now be described in more detail by way of Examples thereof; however, the below-described Examples are merely descriptions of the present invention and should not restrict the present invention by any means. In the below-described Examples, unless otherwise specified, "%" and "part(s)" mean "% by mass" and "part(s) by mass", respectively.

### (Weight-Average Molecular Weight)

The weight-average molecular weight was measured by gel permeation chromatography (GPC). Specifically, a 0.05 to 0.1%-by-mass solution obtained by dissolving a (meth)acrylic polymer in tetrahydrofuran was used as a measurement sample. The measurement conditions were as follows.
Apparatus: manufactured by Tosoh Corporation, product number: HLC-8320GPC
Columns: manufactured by Tosoh Corporation, product numbers: TSKgel G5000H and TSKgel G3000H
Eluent: tetrahydrofuran
Flow rate: 1.0 mL/min
Temperature: 40°C
Detector: RI
Molecular weight standard: standard polystyrene

### Production Example 1: Preparation of (meth)acrylic polymer B1 (Poly-3FPMA)

### (1) Preparation of 3,3,3-trifluoropropyl methacrylate (3FPMA)

In a 1-L five-necked glass flask equipped with a reflux condenser, a water separator, an air introduction tube, a thermometer and a stirrer, 25.0 g of 3,3,3-trifluoropropanol, 18.9 g of methacrylic acid and 5.36 g of N,N-dimethyl-4-aminopyridine were dissolved in 200 g of dichloromethane, and 44.1 g of 1-(3-dimethylaminopropyl)-3-ethylcarbodiimide hydrochloride (hereinafter, referred to as "EDC") was added thereto with stirring on an ice bath, after which stirring was continued for 10 hours. The thus obtained reaction mixture was washed with water, concentrated, and then purified by vacuum distillation, whereby 21.9 g of 3,3,3-trifluoropropyl methacrylate (3FPMA) was obtained as a colorless transparent liquid (GC purity: 99%, yield: 55%). 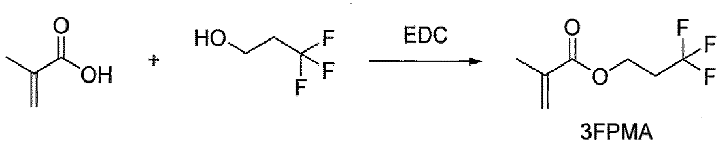 ¹H-NMR (CDCl₃, ppm) of 3FPMA: 1.95(3H,t), 2.44-2.59(2H,m), 4.38(2H,t), 5.58-5.62(1H,m), 6.13-6.14(1H,m)

### (2) Preparation of (meth)acrylic polymer B1 (Poly-3FPMA)

The thus synthesized 3FPMA was polymerized by the below-described procedures to produce a (meth)acrylic polymer B1 (Poly-3FPMA).

In a 30-mL glass container, 0.22 g of 2,4,6-trimethylbenzoyldiphenyl phosphine oxide (trade name "IRGACURE TPO", manufactured by BASF Ltd.; hereinafter, referred to as "TPO") was dissolved as a polymerization initiator in 22.1 g of 3FPMA produced in the above (1) to obtain a mixture containing 3FPMA and the polymerization initiator.

The thus obtained mixture of TPO and 3FPMA was injected into a molding mold made of transparent glass (length: 100 mm, width: 100 mm, depth: 0.5 mm) and subsequently irradiated with UV radiation (irradiation dose: 1.0 mW/m²) to polymerize 3FPMA, whereby a (meth)acrylic polymer B1 (Poly-3FPMA) was obtained. The weight-average molecular weight (Mw) of the thus obtained Poly-3FPMA was measured to be 224,000 by gel permeation chromatography (GPC).

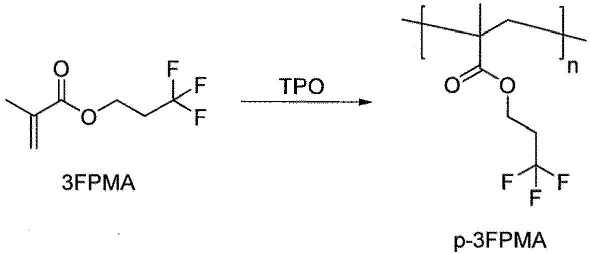

### Production Example 2: Preparation of (meth)acrylic polymer B2 (Poly-3FPA)

### (1) Preparation of 3,3,3-trifluoropropyl acrylate (3FPA)

3FPA was prepared in the same manner as in Production Example 1, except that acrylic acid was used in place of methacrylic acid.
¹H-NMR (CDCl₃, ppm) of 3FPA: 2.45-2.59(2H,m), 4.39(2H,t), 5.88(1H,dd), 6.13(1H,dd), 6.44(1H,dd)

### (2) Preparation of (meth)acrylic polymer B2 (Poly-3FPA)

In a 50-mL glass flask equipped with a nitrogen introduction tube, a thermometer and a stirrer, 10.0 g of 3FPA produced in the above (1) and 10.0 g of butyl acetate were added and stirred to obtain a mixture. To this mixture, nitrogen was introduced from the nitrogen introduction tube for 30 minutes, and the temperature inside the flask was subsequently raised from room temperature to 62°C, followed by an addition of 0.05 g of 2,2'-azobis(2,4-dimethylvaleronitrile) (manufactured by Otsuka Chemical Co., Ltd.; hereinafter, referred to as "ADVN") as a polymerization initiator. The resultant was stirred for 5.5 hours after the addition of ADVN while maintaining the temperature inside the flask at 62°C, and the flask was subsequently cooled to 35°C or lower. The resulting solution inside the flask was taken out and vacuum-dried using a vacuum dryer in a 50°C atmosphere to obtain a (meth)acrylic polymer B2 (Poly-3FPA). The weight-average molecular weight (Mw) of the thus obtained Poly-3FPA was measured to be 230,000 by GPC.

### Production Example 3: Preparation of (meth)acrylic polymer B3 (Poly-FMA)

As FMA which is a monomer, commercially available methyl 2-fluoroacrylate (manufactured by Alfa Aesar) was used. In a 50-mL glass flask equipped with a nitrogen introduction tube, a thermometer and a stirrer, 1.51 g of methyl 2-fluoroacrylate and 6.08 g of γ-butyrolactone were added and stirred, followed by an addition of 0.02 g of TPO as a polymerization initiator, after which nitrogen was introduced from the nitrogen introduction tube to the content so as to perform bubbling for 30 seconds, and the glass flask was then hermetically sealed. Thereafter, the content was stirred with UV radiation being irradiated thereto for 2 hours (irradiation dose: 1.0 mW/cm²), whereby a Poly-FMA was obtained. The weight-average molecular weight (Mw) of the thus obtained Poly-FMA was measured to be 210,000 by GPC.

### Example 1: Production of Composition 1 for Piezoelectric Material and Piezoelectric Material 1

In a capped flask, 0.85 g of a vinylidene fluoride/trifluoroethylene copolymer A1 (P(VDF/TrFE) A1, VDF:TrFE = 75:25 (molar ratio), weight-average molecular weight = 300,000), 0.15 g of the (meth)acrylic polymer B1 (Poly-3FPMA) obtained in Production Example 1, and 4.72 g of diethyl carbonate as a solvent were mixed to produce a composition 1 for a piezoelectric material, which contained the vinylidene fluoride/trifluoroethylene copolymer A1 and the (meth)acrylic polymer B1 at the mass ratio shown in Table 1.

A certain amount of the thus produced composition 1 for a piezoelectric material was supplied to an electrode-equipped evaluation substrate (manufactured by EHC Co., Ltd, ITO-coated glass substrate), and this evaluation substrate was coated with the composition 1 for a piezoelectric material using a spin coater (manufactured by Mikasa Co., Ltd., trade name: 1H-360S) which was accelerated to 700 rpm in 1 second, maintained at this rotation speed for 10 seconds, and then brought to stop in 1 second.

The thus obtained film-coated evaluation substrate was left to stand for 30 seconds and then dried on a hot plate at 70°C for 20 minutes, after which the temperature of the hot plate was raised to 140°C to further dry the evaluation substrate for 1 hour, followed by cooling to room temperature. The thickness of the film was measured to be 15 µm using a stylus-type profiling system (manufactured by Bruker AXS GmbH, trade name: Dektak 150).

Subsequently, the thus cooled film-coated evaluation substrate was set in a resistance heating-type vacuum deposition machine (manufactured by Riken Corporation, trade name: RVC-2-ICP), and gold was evaporated by heating under an atmospheric pressure of 2 × 10⁻⁴ Pa or lower to form an electrode on the surface of the film. Using a high-voltage apparatus (manufactured by Matsusada Precision Inc., trade name: HEOPS-1B30), a triangular wave alternating current having a voltage magnitude of 200 MV/m and a frequency of 0.01 Hz was applied between the electrodes of the resulting film-coated evaluation substrate having the thus formed electrode thereon to prepare the film on the evaluation substrate as a piezoelectric material 1. It is noted here that the electric displacement of a sample was measured through a charge amplifier (manufactured by Turtle Industry Co., Ltd., trade name: T-CAM001BZ). Based on the results thereof, a D (electric displacement) - E (electric field) hysteresis curve was prepared to calculate the remnant polarization of the piezoelectric material 1.

The result obtained for the piezoelectric material 1 of Example 1 is shown in Table 1. In Table 1, "A1" indicates the mixing ratio of the vinylidene fluoride/trifluoroethylene copolymer A1, and "B" indicates the mixing ratio of the respective (meth)acrylic polymers B1 to B3.

### Examples 2 to 6 and Comparative Examples 1 and 2

Piezoelectric materials were prepared in the same manner as in Example 1, except that the formulations of the respective piezoelectric material compositions were changed as shown in Table 1. The results of performing the same measurement for the thus obtained piezoelectric materials are shown in Table 1.

**[Table 1]**

| | | Formulation [% by mass] | | | | Remnant polarization [mC/m²] |
|---|---|---|---|---|---|---|
| | | A1 | B | | | |
| | | | B1 | B2 | B3 | |
| Example | 1 | 85 | 15 | - | - | 164 |
| | 2 | 75 | 25 | - | - | 175 |
| | 3 | 65 | 35 | - | - | 125 |
| | 4 | 50 | 50 | - | - | 108 |
| | 5 | 75 | - | 25 | - | 237 |
| | 6 | 75 | - | - | 25 | 168 |
| Comparative Example | 1 | - | 100 | - | - | 80 |
| | 2 | 100 | - | - | - | 80 to 90 |

As demonstrated in Examples 1 to 6, the piezoelectric materials according to the present invention, which contained a vinylidene fluoride/trifluoroethylene copolymer and a specific (meth)acrylic polymer, were confirmed to have a high remnant polarization. On the other hand, a high remnant polarization was not obtained in those piezoelectric materials containing only either one of a vinylidene fluoride/trifluoroethylene copolymer and a specific (meth)acrylic polymer.

### (Examples 7 to 16 and Comparative Examples 3 to 5)

Piezoelectric materials were prepared in the same manner as in Example 2, except that the formulations of the respective piezoelectric material compositions were changed as shown in Table 2. The vinylidene fluoride/trifluoroethylene copolymer A2 shown in Table 2 had a molar ratio VDF:TrFE of 80:20, and a weight-average molecular weight of 292,000. Further, the vinylidene fluoride/trifluoroethylene copolymer A3 shown in Table 2 had a molar ratio VDF:TrFE of 85:15, and a weight-average molecular weight of 435,000.

### (Measurement of Remnant Polarization)

For each of the piezoelectric materials of Examples 7 to 16 and Comparative Examples 3 to 5, the remnant polarization was measured in the same manner as the method of determining the remnant polarization of the piezoelectric material 1, except that a triangular wave alternating current having a frequency of 0.1 Hz was applied in place of the triangular wave alternating current having a frequency of 0.01 Hz. The results thereof are shown in Table 2. It is noted here that the piezoelectric material compositions and the piezoelectric materials of Examples 8 and 9 and Comparative Example 3 had the same formulations as those of Examples 2 and 4 and Comparative Example 2, respectively.

### (Measurement of Piezoelectric Constant d₃₃)

After measuring the remnant polarization for each of the piezoelectric materials of Examples 7, 10 and 12 to 14 and Comparative Examples 3 and 5, the film on each evaluation substrate was peeled off. For the thus peeled film of each piezoelectric material of these Examples and Comparative Examples, the piezoelectric constant d₃₃ was measured using a piezoelectric constant meter (manufactured by Lead Techno Co., Ltd., trade name: LPF-02).

Specifically, the measurement was performed by the following procedures.
(1) The film was held by a measuring probe.
(2) The load applied to the film from the measuring probe was set at 1 N, and the film was left to stand.
(3) The amount of charge A generated at the time of applying a force of 1 N was measured.
(4) The load applied to the film from the measuring probe was increased by 3 N such that the load applied to the film from the measuring probe was set at 4 N.
(5) The amount of charge B generated at the time of applying a force of 4 N was measured.
(6) The load applied to the film from the measuring probe was reduced by 3 N to 1 N.
(7) Four rounds of the above-described procedures (3) to (6) were performed, and an average value of the difference (A - B) between the amount of charge A and the amount of charge B that were measured in the second to the fourth rounds was defined as the charge amount of each film of Examples and Comparative Examples. This average charge amount was divided by the measuring load (3 N) to calculate the piezoelectric constant d₃₃ of each film of Examples and Comparative Examples. The thus obtained results are shown in Table 2.

**[Table 2]**

| | | Formulation [% by mass] | | | | Remnant polarization [mC/m²] 0.1 Hz | d₃₃ (pC/N) |
|---|---|---|---|---|---|---|---|
| | | A | | | B1 (3FPMA) | | |
| | | A1 (75/25) | A2 (80/20) | A3 (85/15) | | | |
| Example | 7 | 95 | - | - | 5 | 150 | 26 |
| | 8 | 75 | - | - | 25 | 123 | - |
| | 9 | 50 | - | - | 50 | 108 | - |
| | 10 | - | 95 | - | 5 | 190 | 30 |
| | 11 | - | 75 | - | 25 | 116 | - |
| | 12 | - | - | 97 | 3 | 160 | 26.5 |
| | 13 | - | - | 95 | 5 | 163 | 28 |
| | 14 | - | - | 92 | 8 | 143 | 25 |
| | 15 | - | - | 90 | 10 | 140 | - |
| | 16 | - | - | 75 | 25 | 127 | - |
| Comparative Example | 3 | 100 | - | - | - | 80 | 22 |
| | 4 | - | 100 | - | - | 89 | - |
| | 5 | - | - | 100 | - | 86 | 24 |

The piezoelectric materials according to the present invention, which are shown in Examples 7 to 16 and contained a vinylidene fluoride/trifluoroethylene copolymer and a specific (meth)acrylic polymer, were confirmed to have a high remnant polarization. On the other hand, the piezoelectric materials of Comparative Examples 3 to 5, which contained only a vinylidene fluoride/trifluoroethylene copolymer, did not attain a high remnant polarization.

## Claims

1. A piezoelectric material, comprising:
a vinylidene fluoride/trifluoroethylene copolymer; and
a (meth)acrylic polymer which contains a structural unit derived from a (meth)acrylic monomer represented by Formula (I): 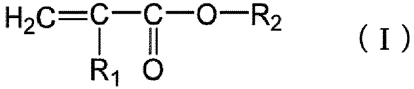 [wherein,
R₁ represents a hydrogen atom or an alkyl group having 1 to 3 carbon atoms, wherein at least one hydrogen atom of R₁ is optionally substituted with a halogen atom; and
R₂ represents a linear or branched alkyl group having 1 to 10 carbon atoms, an alicyclic hydrocarbon group having 3 to 12 carbon atoms which contains an alicyclic structure having 3 to 6 carbon atoms, a phenyl group, or a phenylalkylene group which contains an alkylene group having 1 to 4 carbon atoms,
wherein,
at least one carbon atom of the alkyl group, the alicyclic hydrocarbon group, the phenyl group, and the phenylalkylene group is optionally substituted with -O-, - N-, or -S-,
at least one hydrogen atom of the alkyl group, the alicyclic hydrocarbon group, and the alkylene group is optionally substituted with a hydroxy group, an alkyl group having 1 to 6 carbon atoms, and/or an alkoxy group having 1 to 6 carbon atoms,
at least one hydrogen atom on the phenyl rings of the phenyl group and the phenylalkylene group is optionally substituted with a hydroxy group, an alkyl group having 1 to 4 carbon atoms, an alkoxy group having 1 to 6 carbon atoms, and/or a cyano group, and
at least one hydrogen atom of R₂ is optionally substituted with a halogen atom,
with a proviso that at least one hydrogen atom of R₁ and/or R₂ is substituted with a halogen atom].

2. The piezoelectric material according to claim 1, wherein the amount of the vinylidene fluoride/trifluoroethylene copolymer is 99 to 40% by mass based on the whole piezoelectric material, and the amount of the (meth)acrylic polymer is 1 to 60% by mass based on the whole piezoelectric material.

3. The piezoelectric material according to claim 1 or 2, wherein the vinylidene fluoride/trifluoroethylene copolymer has a weight-average molecular weight of 100,000 or higher.

4. The piezoelectric material according to any one of claims 1 to 3, wherein, in the vinylidene fluoride/trifluoroethylene copolymer, the amount of a structural unit derived from vinylidene fluoride is 55 to 90% by mole based on the amount of all structural units.

5. The piezoelectric material according to any one of claims 1 to 4, wherein the (meth)acrylic polymer has a weight-average molecular weight of 10,000 to 2,000,000.

6. A composition for a piezoelectric material, the composition comprising:
a vinylidene fluoride/trifluoroethylene copolymer; and
a (meth)acrylic polymer which contains a structural unit derived from a (meth)acrylic monomer represented by Formula (I): 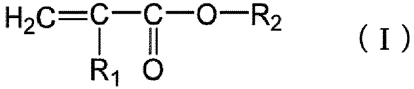 [wherein,
R₁ represents a hydrogen atom or an alkyl group having 1 to 3 carbon atoms, wherein at least one hydrogen atom of R₁ is optionally substituted with a halogen atom; and
R₂ represents a linear or branched alkyl group having 1 to 10 carbon atoms, an alicyclic hydrocarbon group having 3 to 12 carbon atoms which contains an alicyclic structure having 3 to 6 carbon atoms, a phenyl group, or a phenylalkylene group which contains an alkylene group having 1 to 4 carbon atoms,
wherein,
at least one carbon atom of the alkyl group, the alicyclic hydrocarbon group, the phenyl group, and the phenylalkylene group is optionally substituted with -O-,-N-, or -S-,
at least one hydrogen atom of the alkyl group, the alicyclic hydrocarbon group, and the alkylene group is optionally substituted with a hydroxy group, an alkyl group having 1 to 6 carbon atoms, and/or an alkoxy group having 1 to 6 carbon atoms,
at least one hydrogen atom on the phenyl rings of the phenyl group and the phenylalkylene group is optionally substituted with a hydroxy group, an alkyl group having 1 to 4 carbon atoms, an alkoxy group having 1 to 6 carbon atoms, and/or a cyano group, and
at least one hydrogen atom of R₂ is optionally substituted with a halogen atom,
with a proviso that at least one hydrogen atom of R₁ and/or R₂ is substituted with a halogen atom].
at least one hydrogen atom of the alkyl group, the alicyclic hydrocarbon group, and the alkylene group is optionally substituted with a hydroxy group, an alkyl group having 1 to 6 carbon atoms, and/or an alkoxy group having 1 to 6 carbon atoms,
at least one hydrogen atom on the phenyl rings of the phenyl group and the phenylalkylene group is optionally substituted with a hydroxy group, an alkyl group having 1 to 4 carbon atoms, an alkoxy group having 1 to 6 carbon atoms, and/or a cyano group, and
at least one hydrogen atom of R₂ is optionally substituted with a halogen atom,
with a proviso that at least one hydrogen atom of R₁ and/or R₂ is substituted with a halogen atom].
